# EUROPEAN PATENT APPLICATION

(11) **EP 3 982 144 A1**
(43) Date of publication of application: **13.04.2022**
(21) Application number: 20201215.9
(22) Date of filing: 12.10.2020
(51) Int. Cl.: G01R 33/48, G01R 33/561

(54) **SPOILED GRADIENT ECHO MAGNETIC RESONANCE IMAGING WITH SHORT REPETITION TIME**

(71) Applicant: Koninklijke Philips N.V., 5656 AG Eindhoven (NL)
(72) Inventor: EGGERS, Holger, 5656 AE Eindhoven (NL)
(74) Representative: Philips Intellectual Property & Standards

(57) **Abstract**

The invention relates to a method of MR imaging of an object (10) placed in an examination volume of an MR device (1). It is an object of the invention to provide an improved gradient echo imaging method with reduced repetition time by faster spoiling of transverse magnetization. The method of the invention comprises the steps of:
- subjecting the object (10) to a gradient echo imaging sequence comprising a series of temporally equidistant RF excitations, with phase-encoding, refocusing and spoiling magnetic field gradients being applied to sample a pre-defined region of k-space and to generate a gradient echo in each repetition interval, i.e. in each time interval between successive RF excitations, wherein the imaging sequence is divided into a succession of at least two sub-sequences (I, II), the sub-sequences (I, II) being different in amplitudes and/or directions of the spoiling magnetic field gradients applied in each repetition interval of the respective sub-sequence (I, II),
- acquiring echo signals from the object (10), and
- reconstructing an MR image from the acquired echo signals.

Moreover, the invention relates to an MR device (1) and to a computer program to be run on an MR device (1).

## Description

### FIELD OF THE INVENTION

The invention relates to the field of magnetic resonance (MR) imaging. It concerns a method of MR imaging of a portion of a body placed in the examination volume of an MR device. The invention also relates to an MR device and to a computer program to be run on an MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field Bo whose direction at the same time defines an axis (normally the z-axis) of the co-ordinate system on which the measurement is based. The magnetic field B₀ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z-axis to the transverse plane (90° flip angle).

After termination of the RF pulse, the magnetization relaxes back to the original state of equilibrium, in which the magnetization in the z direction is built up again with a first time constant T₁ (spin-lattice or longitudinal relaxation time), and the magnetization in the direction perpendicular to the z direction relaxes with a second time constant T₂ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal, which can also be detected by means of the receiving coils.

In order to realize spatial resolution in the body, constant magnetic field gradients extending along the three main axes are superposed on the uniform magnetic field B₀, leading to a linear spatial dependency of the spin resonance frequency. The signal picked up in the receiving coils then contains components of different frequencies which can be associated with different locations in the body. The signal data obtained via the receiving coils correspond to the spatial frequency domain and are called k-space data. The k-space data usually include multiple lines acquired with different phase-encoding. Each k-space line is digitized by collecting a number of samples. A set of k-space data is converted to an MR image, e.g., by means of Fourier transformation.

So-called "spoiled" gradient echo imaging is widely used in clinical three-dimensional (3D) MR imaging due to its high signal-to-noise efficiency, which is achieved through the use of short repetition times (TR), combined with low flip angles. Transverse magnetization is nulled at the end of each repetition interval, i.e. at the end of each time interval between successive RF excitations, leading to a purely Ti-weighted image contrast. Such fast gradient echo imaging sequences fall into the category of spoiled steady-state imaging sequences as the repetition time, i.e. the duration of each repetition interval, is kept shorter than T₁ and T₂ such that the magnetization is allowed to reach a steady state. A combination of RF spoiling and gradient spoiling is the established spoiling method for gradient echo imaging. It is based on a systematic variation of RF (and receiver) phase in successive repetition intervals and spoiling magnetic field gradients yielding a constant zeroth moment of the magnetic field gradients at the end of each repetition interval (see Zur Y, et al., Magn. Reson. Med. 1991, 21:251-263). In practice, this usually involves spreading out the magnetization within each voxel by a phase offset of at least 2π by the spoiling magnetic field gradients in the readout and the slab-selection direction. Additionally, the phase induced by the variable phase-encoding gradients is offset by matching rewinding gradients.

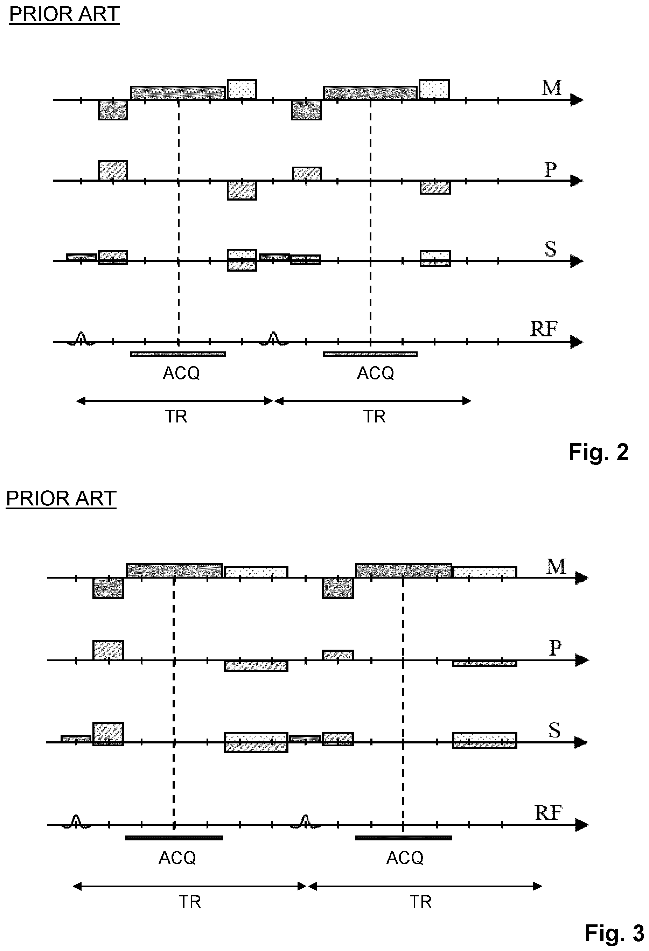

An implementation of a conventional 3D Ti-weighted spoiled gradient echo imaging sequence with Cartesian k-space sampling is illustrated in Fig. 2, showing a schematic and simplified pulse sequence diagram with switched magnetic field gradients in the frequency-encoding (readout) direction M, the phase-encoding direction P, and the slab-selection direction S. Moreover, the diagram shows RF excitations as well as the time intervals during which gradient echo signals are acquired, designated by ACQ. The diagram covers the acquisition of two gradient echo signals in two repetition intervals (repetition time TR). In subsequent repetitions, the phase-encoding magnetic field gradients in the directions P and S (hatched) are varied in amplitude to sample a pre-defined region of k-space, where the matching rewinding gradients are in general also considered as phase-encoding magnetic field gradients herein for the sake of simplicity. Simultaneously, the spoiling gradients (dotted) in the M and S directions remain constant. In the depicted example, the acquired spatial resolution is lower in slab-selection direction S than in the other two directions M and P, and the phase-encoding and spoiling gradients are correspondingly smaller in direction S. However, when the through-plane resolution is required to approach the in-plane resolution, the superposition of spoiling and phase-encoding magnetic field gradients in slab-selection direction S becomes problematic. To prevent excessive demands on the gradient system of the used MR apparatus, the duration of these gradients has to be extended, resulting in longer repetition times TR. This is illustrated in Fig. 3, where the timing from Fig. 2 would lead to an exceeding of the maximum available gradient amplitude in the slab-selection direction S when the required high spoiling and phase-encoding gradients with the same polarity constructively interfere.

### SUMMARY OF THE INVENTION

It is thus an object of the invention to provide an improved gradient echo imaging method with reduced repetition time by faster spoiling of transverse magnetization.

In accordance with the invention, a method of MR imaging of an object placed in an examination volume of a MR device is disclosed. The method comprises the following steps:
- subjecting the object to a gradient echo imaging sequence comprising a series of temporally equidistant RF excitations, with phase-encoding, refocusing and spoiling magnetic field gradients being applied to sample a pre-defined region of k-space and to generate a gradient echo in each repetition interval, i.e. in each time interval between successive RF excitations, wherein the imaging sequence is divided into a succession of at least two sub-sequences, the sub-sequences being different in amplitudes and/or directions of the spoiling magnetic field gradients applied in each repetition interval of the respective sub-sequence,
- acquiring echo signals from the object, and
- reconstructing an MR image from the acquired echo signals.

According to the invention, the (T₁-weighted) gradient echo imaging sequence is split up into two or more sub-sequences. Each of the individual repetition intervals of the gradient echo sequence is assigned to one sub-sequence. The timing of the sub-sequences can then be optimized individually, considering the constraints imposed by the gradient system. In particular, the amplitudes and/or directions of the spoiling magnetic field gradients can be chosen independently to minimize the repetition time, i.e. the duration of the respective repetition interval. The sub-sequences are finally performed sequentially, optionally interspersed with additional spoiling magnetic field gradients and/or RF excitations.

In a practical embodiment, the zeroth moment of the magnetic field gradients applied in each repetition interval is the same for all repetition intervals of each individual sub-sequence but differs from sub-sequence to sub-sequence. In this way, the condition for ideal spoiling, namely that the phase induced by the magnetic field gradients has to be the same in each repetition interval, is only fulfilled separately for each individual sub-sequence. Hence, a fraction of the gained scan time may have to be used for additional spoiling of the transverse magnetization and/or for restoration of the steady-state between the successively performed sub-sequences.

In a preferred embodiment, each of the individual repetition intervals of the gradient echo sequence is assigned to one sub-sequence according to the amplitudes and/or directions of the phase-encoding gradients of the respective repetition interval.

In another preferred embodiment, the amplitudes and/or directions of the spoiling magnetic field gradients applied in each sub-sequence are chosen such that the spoiling magnetic field gradients interfere destructively with the phase-encoding magnetic field gradients applied in this sub-sequence. Destructive interference of the spoiling and phase-encoding magnetic field gradients ensures minimal demands on the gradient system and thus allows minimizing repetition times.

In a possible embodiment, the direction of any of the spoiling magnetic field gradients is reversed between sub-sequences. For example, the repetition intervals with positive phase-encoding magnetic field gradients in the slab-selection direction can be assigned to one sub-sequence while the repetition intervals with negative phase-encoding magnetic field gradients in the slab-selection direction are assigned to another sub-sequence. The polarity of the spoiling magnetic field gradients in the slab-selection direction can then be reversed between the sub-sequences to provide a destructive interference between the spoiling and phase-encoding magnetic field gradients in both sub-sequences.

In yet another possible embodiment, the direction of any of the spoiling magnetic field gradients is switched from one phase-encoding direction to another phase-encoding direction between sub-sequences. When the required resolution is isotropic, the effectiveness of the spoiling is the same in different phase-encoding directions, allowing a choice of the direction based on other criteria, such as minimum repetition time.

Preferably, the temporal order of the individual repetition intervals of the gradient echo sequence is chosen such that the number of sub-sequences is kept small (as small as possible). For instance, the repetition intervals with a positive polarity of the spoiling magnetic field gradient in slab-selection direction are executed first, followed by the repetition intervals with a negative polarity of the spoiling magnetic field gradient in slab-selection direction, which allows dividing the imaging sequence into two sub-sequences only.

In another embodiment, the imaging sequence performs a partial k-space acquisition, i.e. covers k-space asymmetrically in at least one phase-encoding direction. The invention can take advantage of the smaller maximum positive or negative amplitude of the phase-encoding magnetic field gradient in the respective direction, by switching the spoiling magnetic field gradient to this direction and/or by choosing the polarity of the spoiling magnetic field gradient accordingly to obtain destructive interference in the major part of the sampled region of k-space. In this embodiment, the gradient echo sequence does not necessarily have to be divided into sub-sequences.

In yet another embodiment, the method of the invention can be combined with non-Cartesian, in particular radial sampling of k-space. In 3D radial imaging, for instance, the readout magnetic field gradient is rotated around two axes between repetition intervals to sample k-space within a sphere. The rewinding lobe of the readout magnetic field gradient is also considered as a phase-encoding magnetic field gradient herein for the sake of simplicity. The approach of the invention can be used to avoid a constructive interference of the fixed spoiling magnetic field gradient in slab-selection direction and the rotating phase-encoding magnetic field gradient so as to achieve a minimum repetition time.

The imaging sequence of the method of the invention is a spoiled steady-state imaging sequence as the repetition time is shorter than T₁ and T₂ so that the magnetization is enabled to reach a steady state. Thus, the method of the invention involves RF spoiling in combination with the spoiling magnetic field gradients as it is the established spoiling method for gradient echo imaging (see above).

The method of the invention described thus far can be carried out by means of an MR device including at least one main magnet coil for generating an essentially uniform, static magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR device.

The method of the invention can be advantageously carried out on most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR device for carrying out the method of the invention;
Fig. 2 shows a schematic (simplified) pulse sequence diagram of a conventional 3D spoiled gradient echo imaging sequence;
Fig. 3 shows a schematic (simplified) pulse sequence diagram of a conventional 3D spoiled gradient echo imaging sequence with increased resolution in the slab-selection direction;
Fig. 4 shows a schematic (simplified) pulse sequence diagram according to a first embodiment of the invention;
Fig. 5 shows a schematic (simplified) pulse sequence diagram according to a second embodiment of the invention;
Fig. 6 shows a schematic (simplified) pulse sequence diagram for illustration of a third embodiment of the invention.

### DETAILED DESCRIPTION OF THE EMBODIMENTS

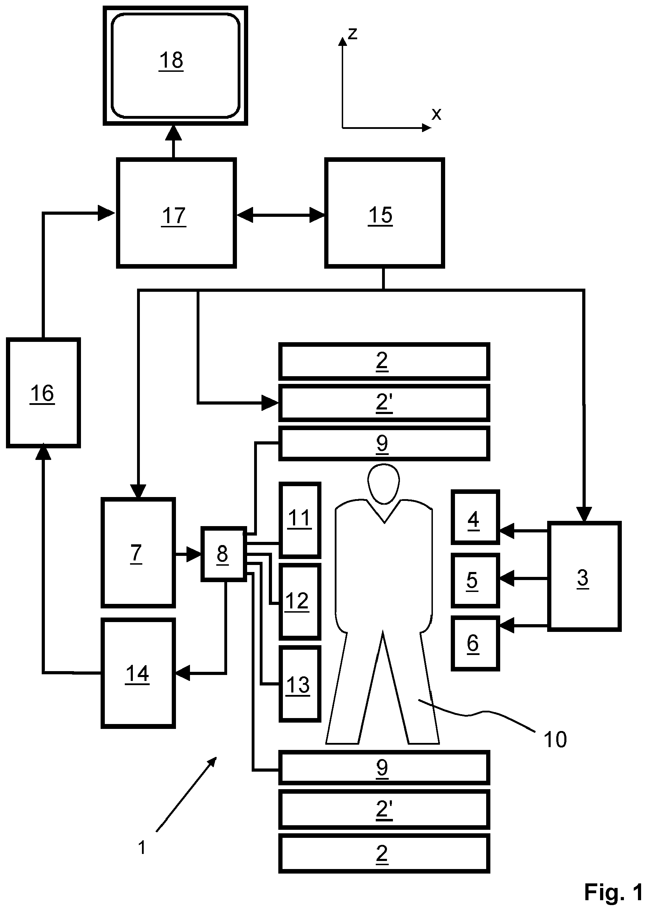

With reference to Fig. 1, a MR device 1 is shown as a block diagram. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert, excite, refocus, and/or spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a RF body coil 9 to transmit RF pulses into the examination volume. A typical MR imaging sequence is composed of a packet of RF pulse segments of short duration which, together with any applied magnetic field gradients, achieve a selected manipulation of magnetic resonance. The RF pulses are used in particular to select a portion of a body 10 positioned in the examination volume. The MR signals are also picked up by the RF body coil 9.

For generation of MR images of limited regions of the body 10, a set of local RF array coils 11, 12, 13 are placed contiguous to the region selected for imaging. The array coils 11, 12, 13 can be used to receive MR signals induced by transmissions of the RF body coil.

The resultant MR signals are picked up by the RF body coil 9 and/or by the RF array coils 11, 12, 13 and demodulated by a receiver 14 preferably including a preamplifier (not shown). The receiver 14 is connected to the RF coils 9, 11, 12 and 13 via the send/receive switch 8. A host computer 15 controls the shimming coils 2' as well as the gradient pulse amplifier 3 and the transmitter 7 to generate the imaging sequences of the invention. For the selected sequence, the receiver 14 receives a single or a plurality of MR data lines in rapid succession following each RF excitation. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a 3D volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are arranged, by corresponding programming, to perform the method of the invention described herein above and in the following.

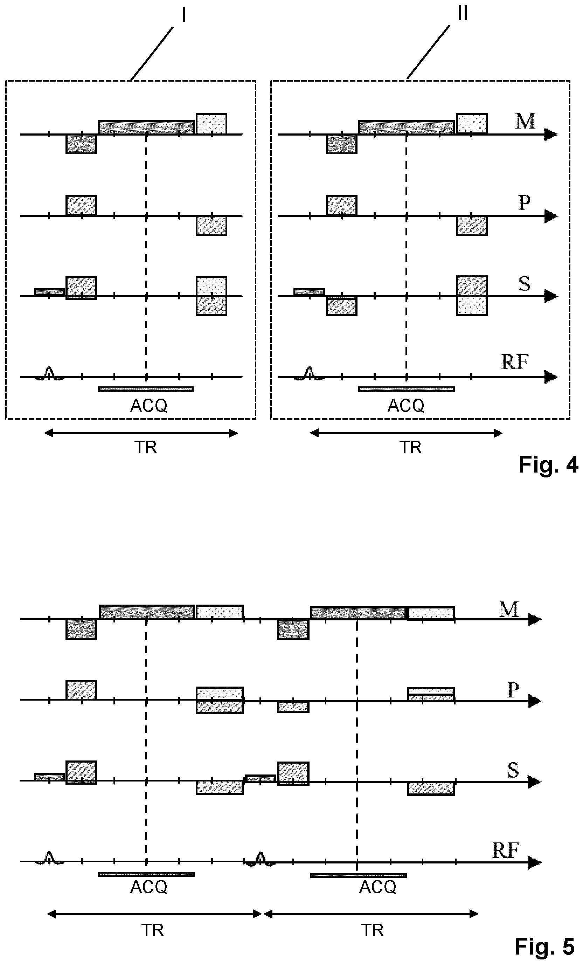

According to the invention, a spoiled 3D gradient echo imaging sequence is performed, which is split into two or more sub-sequences. This is illustrated in Figs. 4-6, in which the imaging sequence is divided into two sub-sequences designated by I and II (see Fig. 4) that are performed in temporal succession, meaning that all repetition intervals of sub-sequence I are performed before all repetition intervals of sub-sequence II. Each of the diagrams of Figs. 4-6 shows switched magnetic field gradients in the frequency-encoding direction M, the phase-encoding direction P, and the slab-selection direction S, applied during two arbitrarily selected repetition intervals of the imaging sequence. Moreover, each diagram shows the RF excitations as well as the time intervals during which echo signals are acquired, designated by ACQ. The repetition time, i.e. the duration of one repetition interval, is indicated by TR. One gradient echo is generated in each repetition interval between successive RF excitations. The position of the respective echo is indicated by the dashed lines. In further repetition intervals (not depicted), the phase-encoding magnetic field gradients in the directions P and S are varied to sample a pre-defined region of k-space.

In the embodiment of Fig. 4, the polarity of the spoiling magnetic field gradient (dotted) in slab-selection direction S is reversed between the two sub-sequences I and II, in correspondence with the polarity of the phase-encoding magnetic field gradient (hatched) in direction S. The repetition intervals of the imaging sequence with positive polarity of the phase-encoding magnetic field gradient in direction S are assigned to sub-sequence I while the repetition intervals with negative polarity of the phase-encoding magnetic field gradient in direction S are assigned to sub-sequence II. By reversing the polarity of the spoiling magnetic field gradient in direction S between sub-sequence I and II, the duration of the spoiling and phase-encoding magnetic field gradients has not to be extended anymore as it is the case in Fig. 3, since they always interfere destructively in the embodiment of Fig. 4 such that the constraints of the gradient system 3, 4, 5, 6 in Fig. 1 are met. The condition that the phase induced by the magnetic field gradients has to be the same in each repetition interval is only met separately for each sub-sequence I, II but not for the imaging sequence as a whole. Thus, a (tolerable) fraction of the gained scan time may have to be used for additional spoiling of the transverse magnetization and/or for restoration of the steady-state between the two sub-sequences I, II.

In the embodiment of Fig. 5, scan acceleration is achieved by a partial k-space acquisition. This can be considered in the selection of the spoiling direction according to the invention. Compared to Fig. 4, a spoiling magnetic field gradient (dotted) is moved from the slab-selection direction S to the phase-encoding direction P to exploit the partial, asymmetrical k-space acquisition in this direction. The maximum amplitude of the phase-encoding magnetic field gradient (hatched) in phase-encoding direction P with positive and negative polarity is depicted in the two repetition intervals shown in Fig. 5 respectively. To take advantage of the smaller maximum amplitude with negative polarity, the spoiling magnetic field gradient is applied in the phase-encoding direction P with positive polarity.

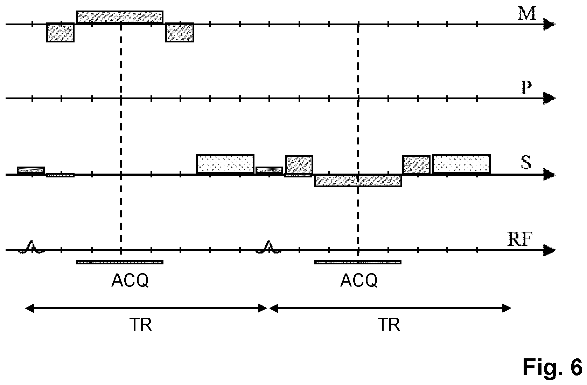

Fig. 6 illustrates an embodiment of the invention for Ti-weighted gradient echo imaging with non-Cartesian, namely radial k-space sampling. The readout and phase-encoding magnetic field gradients (hatched) are rotated around two axes between the repetition intervals to sample k-space within a sphere. To accommodate the case shown in the second repetition interval, in which the phase-encoding magnetic field gradient is aligned with the slab-selection direction S, a constructive interference with the spoiling magnetic field gradient (dotted) is prevented by avoiding a temporal overlap, leading to a significantly longer TR.

The method of the invention, in contrast to the situation shown in Fig. 6, permits ensuring that the spoiling and phase-encoding magnetic field gradients always interfere destructively in each sub-sequence, thus permitting a temporal overlap of these magnetic field gradients and a correspondingly shorter TR (not depicted).

## Claims

1. Method of MR imaging of an object (10) placed in an examination volume of an MR device (1), the method comprising the steps of:
- subjecting the object (10) to a gradient echo imaging sequence comprising a series of temporally equidistant RF excitations with phase-encoding, refocusing and spoiling magnetic field gradients being applied to sample a pre-defined region of k-space and to generate a gradient echo in each repetition interval, i.e. in each time interval between successive RF excitations, wherein the imaging sequence is divided into a succession of at least two sub-sequences (I, II), the sub-sequences (I, II) being different in amplitudes and/or directions of the spoiling magnetic field gradients applied in each repetition interval of the respective sub-sequence (I, II),
- acquiring echo signals from the object (10), and
- reconstructing an MR image from the acquired echo signals.

2. Method of claim 1, wherein the zeroth moment of the magnetic field gradients applied in each repetition interval is the same for all repetition intervals of each individual sub-sequence (I, II).

3. Method of claim 1 or 2, wherein each of the individual repetition intervals of the gradient echo sequence is assigned to one sub-sequence according to the amplitudes and/or directions of the phase-encoding gradients of the respective repetition interval.

4. Method of any one of claims 1-3, wherein the amplitudes and/or directions of the spoiling magnetic field gradients applied in each sub-sequence (I, II) are chosen according to the amplitudes and/or directions of the phase-encoding magnetic field gradients applied in this sub-sequence to minimize the repetition time (TR), i.e. the duration of the respective repetition interval.

5. Method of claim 4, wherein the amplitudes and/or directions of the spoiling magnetic field gradients applied in each sub-sequence (I, II) are chosen such that the spoiling magnetic field gradients interfere destructively with the phase-encoding magnetic field gradients applied in this sub-sequence (I, II).

6. Method of claim 4 or 5, wherein the direction of any of the spoiling magnetic field gradients is reversed between sub-sequences (I, II).

7. Method of any one of claims 1-6, wherein the direction of any of the spoiling magnetic field gradients is switched from one phase-encoding direction to another phase-encoding direction between sub-sequences (I, II).

8. Method of any one of claims 1-7, wherein the temporal order of the individual repetition intervals of the gradient echo sequences is chosen such that the number of sub-sequences is kept small.

9. Method of any one of claims 1-8, wherein the imaging sequence performs a partial k-space acquisition.

10. Method of any one of claims 1-9, wherein the imaging sequence implements non-Cartesian, in particular radial, sampling of k-space.

11. Method of any one of claims 1-10, wherein the imaging sequence involves RF spoiling.

12. MR device comprising at least one main magnet coil (2) for generating a uniform, static magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR device (1) is configured to perform the following steps:
- subjecting the object (10) to a gradient echo imaging sequence comprising a series of temporally equidistant RF excitations. with phase-encoding, refocusing and spoiling magnetic field gradients being applied to sample a pre-defined region of k-space and to generate a gradient echo in each repetition interval, i.e. in each time interval between successive RF excitations, wherein the imaging sequence is divided into a succession of at least two sub-sequences (I, II), the sub-sequences (I, II) being different in amplitudes and/or directions of the spoiling magnetic field gradients applied in each repetition interval of the respective sub-sequence (I, II),
- acquiring echo signals from the object (10), and
- reconstructing an MR image from the acquired echo signals

13. Computer program to be run on a MR device, which computer program comprises instructions for:
- performing a gradient echo imaging sequence comprising a series of temporally equidistant RF excitations, with phase-encoding, refocusing and spoiling magnetic field gradients being applied to sample a pre-defined region of k-space and to generate a gradient echo in each repetition interval, i.e. in each time interval between successive RF excitations, wherein the imaging sequence is divided into a succession of at least two sub-sequences (I, II), the sub-sequences (I, II) being different in amplitudes and/or directions of the spoiling magnetic field gradients applied in each repetition interval of the respective sub-sequence (I, II),
- acquiring echo signals, and
- reconstructing an MR image from the acquired echo signals.
